# EUROPEAN PATENT APPLICATION

(11) **EP 3 339 471 A1**
(43) Date of publication of application: **27.06.2018**
(21) Application number: 17210468.9
(22) Date of filing: 22.12.2017
(51) Int. Cl.: C23C 18/20, C23C 18/16, C23C 18/38

(54) **METHOD FOR ELECTROLESS PLATING**

(30) Priority: 22.12.2016 JP 2016250038
(71) Applicant: Rohm and Haas Electronic Materials LLC, Marlborough, MA 01752 (US)
(72) Inventor: HAKIRI, Yoshiyuki, Agano-shi, Niigata 959-1914 (JP)
(74) Representative: Houghton, Mark Phillip

(57) **Abstract**

To provide a conditioner having less foaming property and having adhesion higher than the conventional conditioner using a cationic polymer or the like and, and an electroless plating method using the same. A method of the present invention for performing an electroless plating including the steps of:
(a) putting the substrate in contact with a composition containing a compound represented by the following general formula (1)

**H₂N-R₁-NH-R₂-NH₂** **(1)**

wherein, R₁ and R₂ are each independently an alkylene group having 3 to 10 carbon atoms;
(b) putting the substrate in contact with a catalyst composition; and (c) putting the substrate in contact with an electroless plating composition.

## Description

### Field of the Invention

The present invention relates to a method for electroless metal plating on a resin substrate, particularly a printed wiring board, and more particularly relates to a method of forming a metal film having high adhesion on the surface of a resin substrate with a pretreatment solution containing a specific compound.

### Background of the Invention

Electrical connection between layers of a printed wiring board is generally performed via very small holes known as through holes. As a method of forming a conductive film on the surface of the printed wiring board and in the inner wall surface of these through holes, a method of treating with a pretreatment solution (also referred to as a conditioner) containing a cationic polymer and a surfactant, applying a catalyst containing palladium and the like, and then forming a metal film by an electroless plating method is generally used.

In order to improve the adhesion between a resin substrate and a conductive film, generally prior to conditioner treatment, a resin-swelling process using a treatment solution primarily containing solvent is performed, then a roughening process using a treatment solution primarily containing a permanganate is performed, and then a series of de-smear/roughening processes that remove the manganese by a neutralization process is performed. De-smear/roughening processes form fine unevenness on the resin surface, thereby improving adhesion between the resin substrate and the conductive film by an anchoring effect.

However, with a method that provides adhesion primarily by an anchoring effect, if the degree of roughness of the resin substrate surface is reduced, the adhesion between the substrate and the metal film will be lowered, and obtaining a plating film with high adhesion will be difficult. Accordingly, there has been a demand for a conditioner having high adhesion even on the surface of resin substrate having a low degree of roughness instead of a conventional conditioner, and an electroless plating method using this conditioner. Further, depending on the compound added to the conditioner, bubbles may be generated on the surface of the liquid; therefore, a conditioner free from such foaming properties has been required.

Japanese Laid-open Patent Publication no. 2006-77289 discloses a pretreatment solution for electroless plating containing a compound having at least two amino groups in one molecule (specifically, a vinylamine (co)polymer or an allylamine (co)polymer). Further, Japanese Laid-open Patent Publication no. 2010-106337 discloses a method of forming a metal film having high adhesion by further adding ammonium hydrogen difluoride to conditioner containing a cationic polymer and a nonionic surfactant.

### Summary of the Invention

Accordingly, it is an object of the present invention to provide a conditioner having less foaming property and having adhesion higher than the conventional conditioner using a cationic polymer or the like and, and an electroless plating method using the same.

The present inventor conducted intensive studies and found that the addition of a triamine compound having a specific alkylene chain length to the conditioner instead of cationic polymer can produce a conditioner having higher adhesion and less foaming property than the cationic polymer. The present invention has been accomplished based on these findings.

In other words, the present invention pertains to a method for performing electroless plating on a substrate comprising the steps of:
(a) putting the substrate in contact with a composition containing a compound represented by the following general formula (1):
   Chemical Formula 1:

   **H₂N-R₁-NH-R₂-NH₂** **(1)**

   wherein, R₁ and R₂ are each independently an alkylene group having 3 to 10 carbon atoms;
(b) contacting the substrate with a catalyst composition; and
(c) contacting the substrate with an electroless plating composition.

### Brief Description of the Drawings

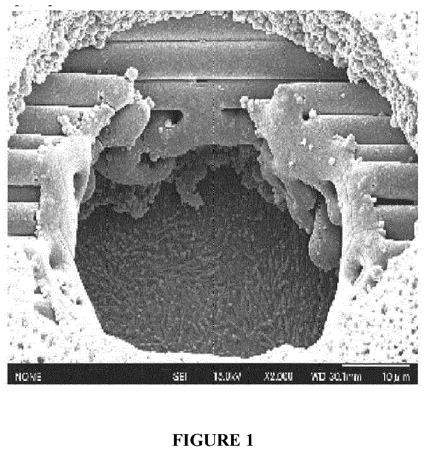

FIG. 1 is a SEM photograph (magnification: 2000 times) showing an inner wall surface of the microvia hole subjected to copper plating in Example 1.

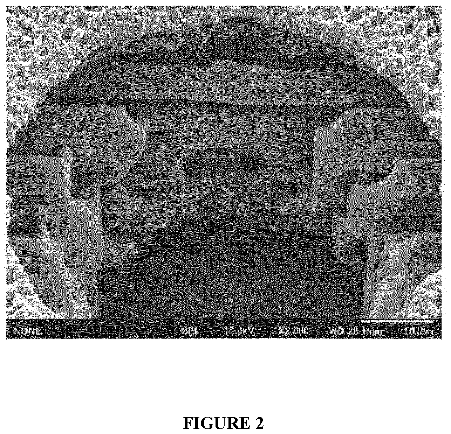

FIG. 2 is a SEM photograph (magnification: 2000 times) showing an inner wall surface of the microvia hole subjected to copper plating in Example 2.

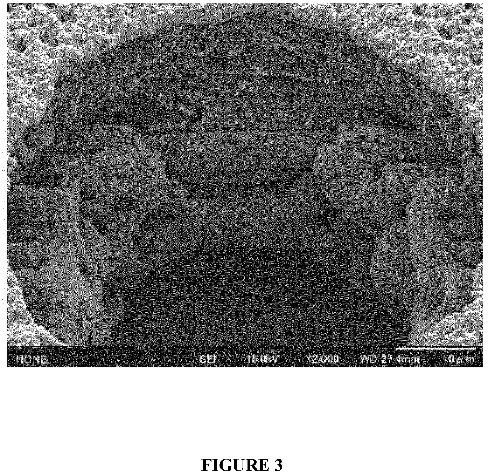

FIG. 3 is a SEM photograph (magnification: 2000 times) showing an inner wall surface of the microvia hole subjected to copper plating in Comparative Example 1.

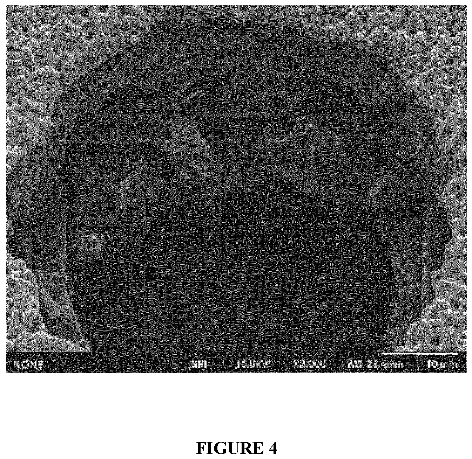

FIG. 4 is a SEM photograph (magnification: 2000 times) showing an inner wall surface of the microvia hole subjected to copper plating in Comparative Example 2.

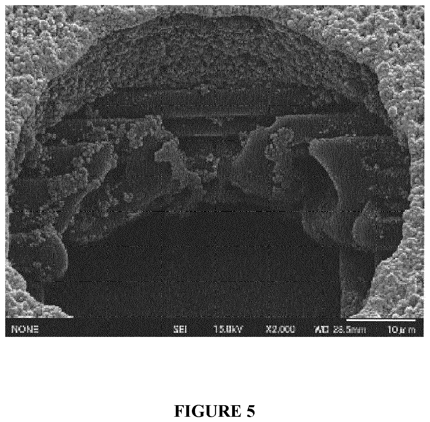

FIG. 5 is a SEM photograph (magnification: 2000 times) showing an inner wall surface of the microvia hole subjected to copper plating in Comparative Example 3.

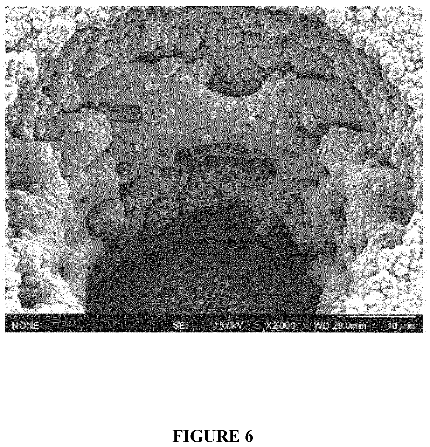

FIG. 6 is a SEM photograph (magnification: 2000 times) showing an inner wall surface of the microvia hole subjected to copper plating in Comparative Example 4.

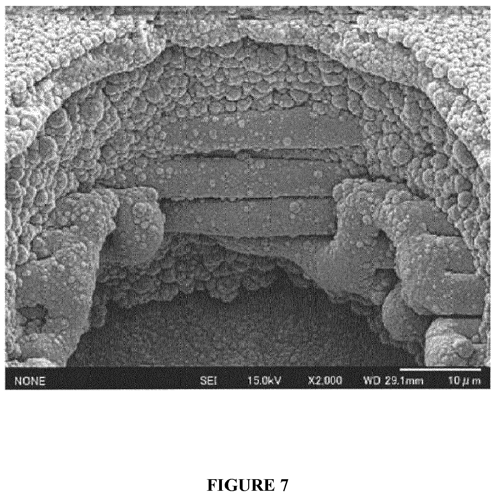

FIG. 7 is a SEM photograph (magnification: 2000 times) showing an inner wall surface of the microvia hole subjected to copper plating in Comparative Example 5.

### Detailed Description of the Invention

The abbreviations used throughout this specification have the following meanings unless otherwise designated. g = gram; mg = milligram; °C = degree Centigrade; min = minute; m = meter; cm = centimeter; L = liter; mL = milliliter; and N = Newton. The range of all values includes the boundary values, and may be combined in any order. In addition, percent (%) means weight% unless otherwise stated in this specification.

In the method of the present invention, a composition containing a compound represented by the following general formula (1):

**H₂N-R₁-NH-R₂-NH₂** **(1)**

is used. The composition can also be called a conditioner. In general formula (1), R₁ and R₂ are each independently an alkylene group having 3 to 10 carbon atoms. The alkylene group may be straight chain or branched chain, but straight chain alkylene group is preferred in the present invention. The alkylene chain preferably has from 3 to 8 carbon atoms, more preferably from 3 to 6 carbon atoms. Specific compounds of general formula (1) include dipropylenetriamine, bis (butylene) triamine, bis (hexamethylene) triamine, and the like.

The present inventor has found that the adhesion is characteristically improved by using a triamine compound having an alkylene chain having 3 to 10 carbon atoms. Although this is not bound by theory, it is believed that triamines having an alkylene chain having 3 to 10 carbon atoms have excellent hydrophilic-lipophilic balance, are easily adsorbed on a resin substrate and at the same time, are easy to bond with the catalyst in the subsequent catalyst application step. Thus, it is possible to form a metal film with high adhesion. Further, although the commonly used cationic polymer has a high adhesion to a resin, it is believed to be easily over-adsorbed because of its large molecular weight. Thus, a relatively large amount of cationic polymer remains between the resin surface and the metal film, thereby deteriorating the adhesion.
The content of the compound, represented by general formula (1), in the conditioner is preferably 0.1 to 10 g/L, more preferably 1 to 8 g/L, and most preferably 2 to 5 g/L. One of the characteristics of the conditioner used in the present invention is that the metal film having high adhesion can be formed even if it does not contain a surfactant. The conditioner containing cationic polymer usually contains a surfactant to increase penetrability of conditioner ingredients into through holes and blind vias, and to impart uniform conditioning action to glass and resin. However, depending on the use condition, the conditioner containing surfactant may produce bubbles on the liquid surface, thereby deteriorating the workability. By using the compound represented by general formula (1), the conditioner of the present invention exhibits higher adhesion than the conventional conditioner even without containing a surfactant.

The conditioner used in the present invention may contain any component in addition to the compound represented by general formula (1). For example, it may contain a chelating agent as an optional component. The chelating agent plays a role in extending the life of the conditioner by forming a chelate compound with the metal ion when the metal ion dissolves into the conditioner. Examples of preferred chelating agents include ethanolamine, triethanolamine, ethylenediaminetetraacetic acid (EDTA), ethylenediamine n, n 'disuccinic acid (EDDS), and iminodiacetic acid (IDA). The amount of chelating agent added is preferably 0.1 to 0.2 mol/L relative to the conditioner.

If necessary, the conditioner used in the present invention can also contain additives such as pH-adjusting agents and the like, as additional optional components. The conditioner used in the present invention preferably contains water as a solvent. Any water can be used such as deionized water, tap water, and the like. Further, a solvent such as alcohol may be mixed with water and used.

The resin substrate can be a printed wiring board, and the printed wiring board can have glass cloth/resin. The resin substrate may have small holes known as through holes or small non-through holes known as blind vias. Furthermore, with a high-density printed wiring board represented by high-performance semiconductor package boards, a functional insulative resin material board is used as the resin substrate. With the method of the present invention, plating can be uniformly deposited not only on the surface of the printed wiring board but also on the inner wall surface of holes if holes such as through holes or the like exist in the substrate.

Examples of the resin substrate include substrates made from epoxy resin, cyanate resin, bismaleimide triazine resin, polyamide, ABS, polyphenyl ether, polysulfone, fluorine resin, polycarbonate, polyacetal, polyphenylene oxide, polypropylene, and liquid crystal polymer, and the like.

Any method that brings the conditioner into contact with the resin substrate is used. For example, the treatment can be performed by immersing a substrate in the conditioner after being subjected to so-called de-smearing or roughening process if necessary, or spraying the conditioner on the substrate. At the time of immersion, the substrate may be immersed in the conditioner at a temperature of 30 to 60°C, preferably 40 to 50°C, for 1 to 10 minutes, preferably 2 to 6 minutes.

After bringing the conditioner into contact with the resin substrate, a catalyst application step is performed to bring the resin substrate into contact with the catalyst composition to adsorb the catalyst on the surface of the resin substrate. However, before bringing the resin substrate into contact with the catalyst composition, a step of immersing the resin substrate (also referred to as microetch) in an aqueous solution such as sodium persulfate, ammonium persulfate, sulfuric acid and hydrogen peroxide mixed solution and a step of washing the surface of the resin substrate with an acid such as sulfuric acid can also be optionally performed. The conditioner used in the present invention can remain on the surface of the resin substrate and on the inner wall surface of the holes even after performing such steps, and a sufficient amount of catalyst can be adsorbed on the surface of the resin substrate and the inner wall surface of the holes in the subsequent catalyst application step. The microetch step can usually be performed using an aqueous solution at a temperature of 20 to 35°C for 0.5 to 10 minutes, preferably 1 to 3 minutes, and the acid washing step can usually be performed at a temperature of 20 to 35°C, preferably 25 to 30°C, for 0.5 to 5 minutes, preferably 1 to 3 minutes.

A conventionally known catalyst composition may be used. Examples of the catalyst composition include a palladium-tin colloid solution, a composition containing metal ions such as palladium, platinum, silver or copper, and the like. For example, CIRCUPOSIT™ ADV 8530 Catalyst and CIRCUPOSIT™ 6530 Catalyst (both manufactured by Rohm and Haas Electronic Materials Co., Ltd.) can be used. In the case of using CIRCUPOSIT™ ADV 8530 catalyst as a catalyst composition, for example, the resin substrate is immersed in the catalyst composition at a temperature of 35 to 60°C, preferably 40 to 50°C, for 1 to 10 minutes, preferably 3 to 5 minutes, and then a deduction treatment of palladium ions can be performed with CIRCUPOSIT™ 6540 reducer.

A conventionally known electroless plating composition may be used. For example, an electroless plating composition containing metals such as copper, nickel, cobalt, iron or the like or a mixture thereof can be used. Electroless copper plating is usually preferred when using a printed wiring board as the resin substrate. For example, CIRCUPOSIT™ 6550 electroless copper, CIRCUPOSIT™ ADV 8550 electroless copper, and CIRCUPOSIT™ 328 copper mix concentrate (all manufactured by Rohm and Haas Electronic Materials Co., Ltd.) can be used.
Hereinafter, the present invention will be described in more detail with reference to examples, but the present invention is not limited to these examples.

In the following Examples and Comparative Examples, plating deposition on the inner wall surface of the through holes was evaluated by SEM observation. Adhesion strength was also evaluated according to the following procedure: The surface of the substrate subjected to the electroless plating was washed with deionized water for 3 minutes at room temperature and heated and dried (120°C, 30 minutes). Then, the surface of the material to be plated was immersed in an acid cleaner (liquid temperature of 35°C, 2 minutes) containing sulfuric acid. Thereafter, acid washing was performed, and electrolytic copper plating treatment was performed with electrolytic copper plating MICRO FILL™ EVF. The surface of the resultant plated material was washed with deionized water at room temperature for 3 minutes, and then heated and dried (180°C, 60 minutes). The resulting copper plating film had a film thickness of 20 to 25 µm, and this plating film was cut in 1-cm widths. The adhesion strength (peel strength) between the substrate resin and the plating film was measured using an INSTRON™ 5564 tester at a tensile speed of 50 mm/minute and at an angle of 90° in accordance with the JIS C5012 printed wiring board test method.

### Examples 1 to 6 and Comparative Examples 1 to 5

The following resin substrates 1 to 3 were used as the resin substrate of the material to be treated.

### Resin substrates

Resin substrate 1: Ra: 100 (nm)
Resin substrate 2: Ra: 250 (nm)
Epoxy resin substrate 3: Ra: 80 (nm)
Note: Ra represents an arithmetic average roughness.

Each compound shown in Table 1 or Table 2 was added to deionized water in the amounts shown in Table 1 or Table 2 to prepare a conditioner. The resin substrates 1 to 3 were subjected to a de-smearing/roughening process using a permanganate salt, and then immersed in the conditioner at a temperature of 45°C for 5 minutes. Next, soft etching was performed using sodium persulfate. After washing with acid, a catalyst imparting treatment using an alkaline palladium catalyst (CIRCUPOSIT™ ADV 8530 Catalyst) and a reduction treatment using a CIRCUPOSIT™ 6540 Reducer were performed. Then, electroless copper plating was performed by immersing in an electroless copper plating solution (CIRCUPOSIT™ ADV 8550 electroless copper) at a temperature of 32°C for 20 minutes. Between each treatment, washing with deionized water was performed at room temperature for 2 minutes. The state of plating deposition in the micro via hole after electroless copper plating was observed with SEM. Next, electrolytic copper plating treatment was performed and then adhesion testing was performed. The evaluation results are also shown in Table 1 or Table 2.

In Examples 1 and 2, dipropylenetriamine and bis(hexamethylene) triamine were added, respectively, as the compounds (conditioner components) of the conditioner. In Comparative Examples 1 and 2, diethylenetriamine and monoethanolamine were used instead of the compounds of Examples, and in Comparative Example 3, the test was carried out only with deionized water without adding any conditioning components. In Comparative Examples 4 and 5, commercial conditioners 231 and 3328 were used, respectively, (both manufactured by Rohm and Haas Electronic Materials, containing cationic polymer, chelating agent, nonionic surfactant, and water, pH: about 10 and 1).

**Table 1**

| Example | | 1 | 2 |
|---|---|---|---|
| Compound | | Dipropylenetriamine | Bis(hexamethylene) triamine |
| Addition amount (g) | | 5.0 | 2.0 |
| Copper deposition state | | Good (FIG. 1) | Good (FIG. 2) |
| Peel strength (kN/m) | Resin 1 | 0.506 | 0.520 |
| | Resin 2 | 0.338 | 0.410 |
| | Resin 3 | 0.272 | 0.284 |
| Comprehensive evaluation | | Good (Good copper deposition with high peel strength) | Good (Good copper deposition with high peel strength) |

**Table 2**

| Comparative Example | | 1 | 2 | 3 | |
|---|---|---|---|---|---|
| Compound | | Diethylenetriamine | Monoethanolamine | - | |
| Addition amount (g) | | 5.0 | 2.0 | | |
| Copper deposition state | | Partial deposition (FIG. 3) | Almost no deposition (FIG. 4) | Almost no deposition (FIG. 5) | |
| Peel strength (kN/m) | Resin 1 | 0.528 | 0.568 | Not performed due to poor deposition | |
| | Resin 2 | 0.376 | 0.413 | Not performed due to poor deposition | |
| | Resin 3 | 0.275 | 0.289 | Not performed due to poor deposition | |
| Comprehensive evaluation | | Good peel strength but poor copper plating deposition | Good peel strength but poor copper plating deposition | Poor | |

**Table 3**

| Comparative Example | | 4 | 5 |
|---|---|---|---|
| Commercial conditioner | | 231 | 3328 |
| Copper deposition state | | Good (FIG. 6) | Good (FIG. 7) |
| Peel strength (kN/m) | Resin 1 | 0.463 | 0.493 |
| | Resin 2 | 0.345 | 0.366 |
| | Resin 3 | 0.176 | 0.125 |
| Comprehensive evaluation | | Good copper deposition but low adhesion strength (peel strength) | Good copper deposition but low adhesion strength (peel strength) |

## Claims

1. A method for performing an electroless plating on a substrate comprising the steps of:
(a) putting the substrate in contact with a composition containing a compound represented by the following general formula (1)
**H₂N-R₁-NH-R₂-NH₂** **(1)**
wherein, R₁ and R₂ are each independently an alkylene group having 3 to 10 carbon atoms;
(b) putting the substrate in contact with a catalyst composition; and
(c) putting the substrate in contact with an electroless plating composition.

2. The method according to claim 1, wherein the content of the compound, represented by general formula (1), in the composition is from 0.1 to 10 g/L.

3. The method according to claim 1 or 2, wherein the electroless plating is electroless copper plating.

4. A substrate having a metal film on at least a part of its surface obtained by the method according to claim 1.
